# EUROPEAN PATENT APPLICATION

(11) **EP 1 530 285 A1**
(43) Date of publication of application: **11.05.2005**
(21) Application number: 03386026.3
(22) Date of filing: 04.11.2003
(51) Int. Cl.: H03B 29/00

(54) **Generator of electromagnetic white noise**

(71) Applicant: Aggelopoulos, Dimitris Platon, 152 37 Athens (GR); Chaloftis, Kostas George, Kalithea 17671, Athens (GR)
(72) Inventor: Aggelopoulos, Dimitris Platon, 152 37 Athens (GR); Chaloftis, Kostas George, Kalithea 17671, Athens (GR)

(57) **Abstract**

Generator of electromagnetic white noise which does not operate with oscillation or sweep as the existing noise generators, but by producing a very broad band of white noise ranging from 1 Hz to 13GHz with continuous operation, that is it produces successive emissions of a very broad band where the time between two emissions is in the order of a few picoseconds or even atoseconds, so that the final emitted noise signal resembles the natural noise. This is achieved with the use of a reversely polarized PNP or NPN transistor With this reverse voltage connection is achieved the partial split of the electron flux and as a result a noise signal is produced, which thereafter is amplified, through several amplification stages, until we receive white noise with exploitable emitted power.

## Description

This invention refers to a generator for the production of electromagnetic white noise This generator produces emitted white noise, of uncountable, infinite frequencies of a very broad band, without operating with sweep or oscillation. The very broad band that it produces and emits ranges from 1 Hz to 13 GHz.

A previous technical level constitute the RF-microwave generators of a very broad band, with a fixed or variable central frequency which operate with sweep or oscillation, that is they produce a very broad frequency band using an oscillator resonated to a central frequency and a multitude of harmonics below and above their central frequency in fixed or variable time. For example, in one msec they produce a very broad band of harmonics and in the next msec they produce another very broad band and so on, so that with this repetitive oscillation they produce noise with a multitude of countable frequencies.

The present generator does not operate in this way, but it produces without sweep, with simultaneous, constant and oscillating operation, a multitude of uncountable, infinite frequencies. That is it produces successive emissions of a very broad band where the time between two emissions is in the order of a few picoseconds or even atoseconds and the spectrum that it emits resembles the natural or cosmic noise. This is succeeded with the use of a PNP transistor with reverse polarity, that is using reversely polarized the semiconductor NP with a positive voltage causes a partial split of the electron flux and as a result noise is produced. Then, with the amplification of this produced signal there is produced exploitable white noise in emission levels.

An advantage of this generator is that with a simple and cheap coupling the production of strong emitted white noise is possible.

Another advantage is the steep increase of the emission of information due to the infinite multitude of emitted frequencies.

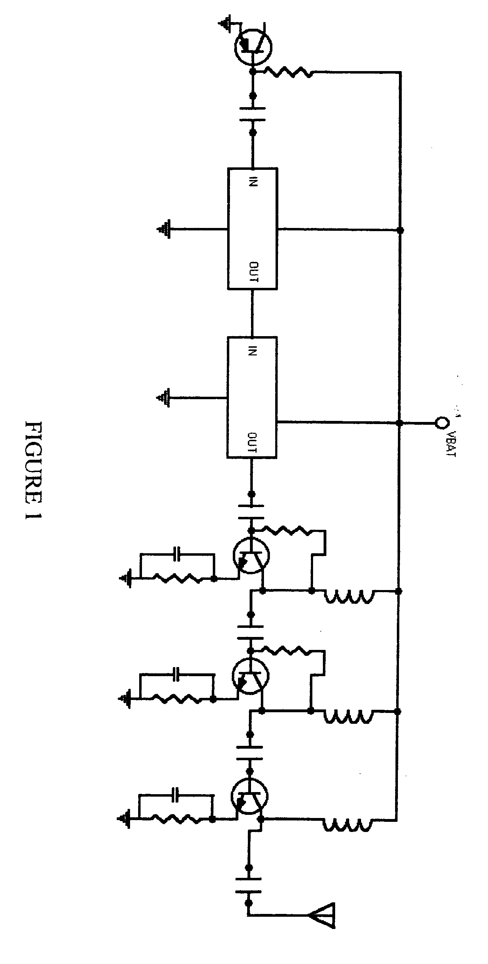

For the construction of the generator (Figure 1) we receive a PNP or NP semiconductor and we supply it with reverse polarity. That results in the production of a noise signal of infinite frequencies. Then, we amplify the noise emitted by the split or movement of the electrons with a series of hybrid integrated circuits and transistors until we get white noise with an exploitable emission power.

Also, it has been experimentally observed that the use of noble metals only in the construction of the generator contributes to the improvement of the emission quality. Particularly the noble metals Ag, Pt, Pd and Rh are ideal for anticlockwise, from the emission antenna, polarized emission, and the noble metals Au, Ir and Ru are ideal for clockwise, from the emission antenna, polarized emission.

## Claims

1. Generator of electromagnetic white noise **characterized by** the fact that using a PNP or NPN transistor with reversed polarity there is produced noise of uncountable frequencies.

2. Generator of electromagnetic white noise according to Claim 1, **characterized by** the fact that the produced noise signal from the reversed polarity of a PNP or NPN transistor, is amplified through several amplification stages until the production of the desired level of emitted white noise with exploitable power
